# EUROPÄISCHE PATENTSCHRIFT

(11) **EP 0 485 838 B1**
(45) Veröffentlichungstag und Bekanntmachung des Hinweises auf die Patenterteilung: **18.10.1995**
(21) Anmeldenummer: 91118730.0
(22) Anmeldetag: 04.11.1991
(51) Int. Cl.: H05K 3/20, H05K 3/00

(54) **Spritzgegossene Leiterplatten durch Hinterspritzen von flexiblen Schaltungen mit thermoplastischen Materialien**
Injection molded circuit boards by injection behind flexible circuits with thermoplastic materials
Plaques à circuit moulées par injection arrière de circuits flexibles par des matériaux thermoplastiques

(30) Priorität: 16.11.1990 DE 4036592
(43) Veröffentlichungstag der Anmeldung: 20.05.1992
(73) Patentinhaber: BAYER AG, 51368 Leverkusen (DE)
(72) Erfinder: Wolf, Gerhard Dieter, Dr., W-4047 Dormagen 5 (DE); Giesecke, Henning, Dr., W-5000 Köln 80 (DE); Wank, Joachim, Dipl.-Ing., W-4047 Dormagen 5 (DE)

(56) Entgegenhaltungen:
- EP-A- 0 067 902
- DE-A- 3 627 256
- DE-B- 1 243 746
- DE-C- 3 840 542
- US-A- 4 772 496
- FEINWERKTECHNIK + MESSTECHNIK Bd. 96, Nr. 3, März 1988, MUENCHEN DE Seiten 95 -97;STEFFEN:'Additive Leiterplattenherstellung'

## Beschreibung

Die vorliegende Erfindung betrifft Verfahren zur Herstellung spritzgegossener Leiterplatten. Das Wesen der Erfindung besteht darin, daß flexible Trägermaterialien mit thermoplastischen Materialien hinterspritzt werden, auf denen nach dem Hinterspritzen die Leiterbahnen durch bestimmte voll- oder semiadditive Techniken aufgebracht werden.

Das Hinterspritzen von Folien mit thermoplastischen Materialien zur Herstellung dekorativer Formkörper und auch zur Herstellung von Spritzgußteilen, die elektrische bzw, elektronische Schaltungen aufweisen und somit auch "spritzgegossene Leiterplatten" genannt werden können, sind bekannt.

So werden flexible Schaltungen, d. h. Folien, die auf einer Seite Leiterbahnen enthalten oder auch solche, bei denen auf beiden Seiten Leiterbahnen angeordnet sind und beide Seiten ggf. auch durch durchmetallisierte Bohrlöcher ("Durchsteiger") elektrisch miteinander verbunden sind, in Spritzgußwerkzeuge eingelegt und mit einem thermoplastischen Material hinterspritzt. Auf diese Weise können auch Leiterplatten hergestellt werden, bei denen die elektrischen/elektronischen Schaltungen in einer Ebene angeordnet sind. Vorzugsweise jedoch bedient man sich dieser Hinterspritztechnik, um dreidimensionale "spritzgegossene Schaltungen" herzustellen (EP- A 0 067 902).

Die flexiblen Schaltungen für die Herstellung der spritzgegossenen Leiterplatten können dadurch hergestellt werden, daß man auf eine Trägerfolie mit Hilfe der Siebdrucktechnik eine leitfähige Paste, vorzugsweise eine Paste die Ag-, Cu-, Ni-Pulver oder Graphit enthält, in Form des Schaltungsbildes aufdruckt (WO 87/01557).

Ebenso können solche flexiblen Schaltungen für die Herstellung der spritzgegossenen Leiterplatten eingesetzt werden, die durch Subtraktiv-Verfahren erhalten worden sind. Zu ihrer Herstellung werden auf Trägerfolien Kupferfolien mit Hilfe eines Klebers aufkaschiert, die Kupferoberfläche nach üblichen Techniken mit einem Ätzresist in Form des Leiterbahnenbildes versehen, die nicht bedeckten Stellen der Kupferfolie in einem üblichen Kupferätzbad abgeätzt und schließlich der Ätzresist wieder gestrippt.

In einer besonderen Ausführungsform zur Herstellung der spritzgegossenen Schaltungen wird die kupferkaschierte Folie, bei der die Kupferoberfläche partiell, d. h. in Form des Leiterbahnenbildes mit einem Ätzresist versehen ist, in die Spritzgußform eingelegt und mit einem Thermoplasten hinterspritzt. Das Herstellen der Leiterbahnen erfolgt am dreidimensionalen Spritzgußteil durch Abätzen der nicht mit Ätzresist bedeckten Kupferzonen (US-PS 4 710 419).

Die beschriebenen Verfahren weisen verschiedene Nachteile auf:
- Die Leiterbahnen, die aus Metallpulver-gefüllten Polymeren bestehen, besitzen eine relativ niedrige Leitfähigkeit und lassen sich nicht löten, was den Einsatz derartiger Schaltungen stark einschränkt.
- Flexible Schaltungen, die für das Hinterspritzen aus mit Kupferfolie-kaschierten Trägerfolien, vorzugsweise Polyimid-Folien, durch Subtraktiv-Verfahren hergestellt worden sind, besitzen folgende nachteilige Merkmale:
   - Die Kupferschichtdicke beträgt mind. 17,5 µm. Leiterbahnen dieser oder einer höheren Schichtdicke können an Ecken und Kanten der durch Hinterspritzen herzustellenden dreidimensionalen Körper Brüche erleiden. Schon eine Unterbrechung in einer Leiterbahn verursacht bereits die Funktionsuntüchtigkeit der gesamten Schaltung.
   - Die für das haftfeste Aufkaschieren notwendige Kleberzwischenschicht (20 - 30 µm dick) besitzt niedrigere elektrische und thermische Eigenschaften als das flexible Trägermaterial, vorzugsweise die Kapton ®-Folie, Dies wirkt sich besonders dann nachteilig aus, wenn Schaltungen mit feinen Leiterbahnen hergestellt werden sollen.

Es wurde nun ein Verfahren zur Herstellung spritzgegossener Leiterplatten durch Hinterspritzen von flexiblen Schaltungen in Spritzgußformen mit einem thermoplastischen Polymermaterial gefunden, das die beschriebenen Nachteile vermeidet und zu spritzgegossenen Leiterplatten mit ausgesprochen hoher Qualität führt.

Die Erfindung betrifft demnach ein Verfahren zur Herstellung spritzgegossener Leiterplatten durch Hinterspritzen von flexiblen Schaltungen in Spritzgußformen mit einem thermoplastischen Polymermaterial, das dadurch gekennzeichnet ist, daß flexible Träger eingesetzt werden, auf deren Oberfläche eine einen Metallisierungsaktivator enthaltende Pastenformulierung entweder
a) in Form des Leiterbahnenbildes aufgedruckt ist, und nach dem Hinterspritzen und Sensibilisieren durch Reduktion in einem chemischen, stromlosen Metallisierungsbad eine Metallschicht in Form des gewünschten Leiterbahnenbildes und in der Höhe von 0,05 - 10 µm aufgebaut wird, oder
b) ganzflächig aufgebrach wird, und nach dem Hinterspritzen und Sensibilisieren durch Reduktion in einem chemischen, stromlosen Metallisierungsbad eine 2 - 3 µm dicke Metallschicht ganzflächig aufgebaut wird, auf deren Basis nachfolgend nach der Semiadditiv-Technik ein Leiterbahnenbild aufgebaut wird, oder
c) ganzflächig aufgebracht wird, dann in Form des negativen Leiterbahnenbildes ein Galvanoresist aufgebracht wird, und nach dem Hinterspritzen und Sensibilisieren durch Reduktion in einem chemischen, stromlosen Metallisierungsbad eine Metallschicht mit einer Dicke von 0,05 - 10 µm in Form des Leiterbahnenbildes aufgebaut wird, wobei in allen Ausführungsformen a), b) und c) das Sensibilisieren durch Reduktion durch das Metallisierungsbad durchgeführt werden kann.

In der erfindungsgemäßen Ausführungsform kann besonders gut vermieden werden, daß während des Hinterspritzens die Leiterbahnen an den Kanten und Ecken der herzustellenden dreidimensionalen Schaltungen brechen könnten. Bei dieser Ausführungsform werden für das additive Verfahren flexible Träger eingesetzt, auf deren Oberfläche eine einen Aktivator enthaltende Pastenformulierung in Form des Leiterbahnenbildes aufgedruckt ist, die in diesem noch nicht metallisierten Zustand mit einem thermoplastischen Material hinterspritzt werden, wobei dann nach dem Hinterspritzen in einem chemischen, stromlosen Kupferbad der Aufbau der Kupferschicht in Form des gewünschten Leiterbahnenbildes und in der Höhe von 0,05 - 10 µm, vorzugsweise 0,1 - 4 µm, erfolgt.

Selbstverständlich können auch flexible Träger eingesetzt werden, auf deren Oberfläche eine einen Aktivator enthaltende Pastenformulierung ganzflächig aufgebracht ist, um nach dem Hinterspritzen in einem chemischen, stromlosen Metallbad eine ca. 2 -3 µm dicke Metallschicht ganzflächig aufzubauen, auf deren Basis nachfolgend nach der Semiadditiv-Technik der Aufbau eines Leiterbahnenbildes durchgeführt werden kann.

In einer weiteren Ausführungsform werden flexible Träger eingesetzt, auf deren Oberfläche eine einen Aktivator enthaltende Pastenformulierung ganzflächig aufgebracht ist und zusätzlich ein Galvanoresist in Form des negativen Leiterbahnenbildes aufgebracht ist, wobei nach dem Hinterspritzen in einem chemischen, stromlosen Kupferbad eine Schaltung in Form des gewünschten Leiterbahnenbildes mit einer Kupferschichtdicke von 0,05 - 10 µm, vorzugsweise 1 -5 µm, aufgebaut wird.

In einer weiteren bevorzugten Ausführungsform des Verfahrens zur Herstellung spritzgegossener Leiterplatten werden flexible Träger eingesetzt, auf denen die einen Metallisierungaktivator-enthaltende Pastenformulierung aufgebracht worden ist, die aber vor dem Hinterspritzen nach einer Blasverformungstechnik vorgeformt worden sind. Selbstverständlich können auch die oben beschriebenen metallisierten Schaltungen vorgeformt werden.

Zur Blasverformung der flexiblen Träger können verschiedene übliche Vakuum- oder Preßluftverformungsverfahren zur Anwendung gelangen. Bevorzugt wird aber eine Hochdruckverformungstechnik angewendet, wie sie beispielsweise in der DE-OS 38 40 542 beschrieben ist.

Zur Herstellung der für das Hinterspritzen einzusetzenden flexiblen Schaltungen können verschiedenartige Foliensubstrate eingesetzt werden. Beispiele sind: Folien aus Polyethylen, Polypropylen, Polyvinylchlorid, aus Polyamiden, Polyalkylen- und Polyarylenterephthalaten, aus Polysulfonen, Polyphenylensulfid, Polycarbonaten und Polyimiden. Besonders bevorzugt sind Substrate, wie sie in der Leiterplattenfertigung eingesetzt werden, beispielsweise Polyester-, Polycarbonat- und Polyimidfolien.

Neben den Polyimiden kommen weiterhin Polyimid-ähnliche Folien in Betracht, wobei unter Polyimid-ähnlichen Substraten solche verstanden werden, die neben Polyimidgruppen noch andere funktionelle Gruppen, wie beispielsweise Amid-, Ester-, Ether-, Sulfon- oder Sulfatgruppen enthalten.

Zur Herstellung von Schaltungen auf den beschriebenen Trägerfolien werden Aktivator-enthaltenden Formulierungen, wie Siebdruckpasten partiell, d. h. in Form eines Leiterbahnenbildes, auf die Foliensubstrate aufgedruckt. Nach dem Trocknen der aufgedruckten Formulierungen und dem Hinterspritzen können die gedruckten Strukturen durch Eintauchen in geeignete Metallisierungsbäder metallisiert werden.

Es kann aber so verfahren werden, daß die Aktivatorenthaltenden Formulierungen ganzflächig aufgebracht werden, beispielsweise aufgedruckt oder aufgerakelt werden, und daß dann nach dem Trocknen und dem Hinterspritzen auf den aufgebrachten Formulierungen durch Tauchen in geeignete Metallisierungsbäder ganzflächig dünne Metallschichten erzeugt werden. Auf der Basis dieser dünnen Metallschichten lassen sich dann nach dem üblichen Semiadditiv-Techniken Schaltungen herstellen.

Als Aktivatoren-enthaltende Formulierungen werden bevorzugt solche eingesetzt, die in DE-OS 36 25 587, DE-OS 36 27 256 und DE-OS 37 43 780 beschrieben sind.

Nach dem Aufbringen der Aktivatoren-enthaltenden Formulierungen auf die Folienoberfächen werden - wie bereits beschrieben - die Lösungsmittel durch Trocknen entfernt.

Das Trocknen kann bei unterschiedlichen Temperaturen, beispielsweise zwischen Raumtemperatur und 350°C unter Normaldruck oder auch im Vakuum erfolgen. Die Trocknungszeit kann selbstverständlich stark variiert werden.

Die auf die Folienoberflächen partiell oder ganzflächig aufgebrachten Aktivatoren-enthaltenden Formulierungen müssen nach dem Trocknen und dem Hinterspritzen durch Reduktion sensibilisiert werden. Dazu können bevorzugt die in der Galvanotechnik üblichen Reduktionsmittel wie z.B. Formaldehyd, Hypophosphite und Borane verwendet werden.

Eine besonders bevorzugte Ausführungsform besteht darin, daß die Reduktion im Metallisierungsbad gleich mit dem Reduktionsmittel der stromlosen Metallisierung durchgeführt wird. Diese Ausführung ist besonders für Amidboran-haltige Nickelbäder oder Formalin-haltige Kupferbäder geeignet.

Die mit den Formulierungen aktivierten Folienoberflächen werden nach dem Hinterspritzen in einem weiteren Verfahrensschritt metallisiert. Dafür kommen besonders Bäder mit Nickel-, Cobalt-, Eisen-, Kupfer-, Silber-, Gold-und Palladiumsalzen oder deren Gemische in Betracht. Derartige Metallisierungsbäder sind in der Technik der stromlosen Metallisierung bekannt.

Besonders bevorzugt für die Herstellung von flexiblen Schaltungen nach vorliegender Erfindung sind Formalinhaltige Kupferbäder. Die Verkupferung kann im Prinzip in verschiedenartigen handelsüblichen stromlosen Verkupferungsbädern erfolgen. Beispiele für derartige Bäder sind: Cuposit® Copper Mix 328 Cu der Fa. Shipley, Cuposit® Cp-78 der Fa. Shipley, Dynaplate® Electroless Copper 850 der Fa. Dynachem, Enplate® Cu 701 der Fa. Imasa, Enplate® Cu 872 der Fa. Imasa, Printoganth® ML der Fa. Schering oder Noviganth® T der Fa. Schering. Besonders bewährt hat sich für die Herstellung der flexiblen Schaltungen mit den beschriebenen Aktivatorenenthaltenden Formulierungen das Kupferbad Printoganth^{R} ML der Fa. Schering.

Wie oben ausführlich dargelegt, erfolgt die Metallisierung der aufgedruckten Aktivatoren-enthaltenden Pasten nach dem Hinterspritzen durch Tauchen des fertigen mit der bedruckten Folie haftfest verbundenen Spritzgußteils in eines der beschriebenen Metallisierungsbäder.

Ebenfalls ist bereits dargelegt worden, daß zur Herstellung der Schaltungen entweder nach der additiven oder nach der semiadditiven Technik verfahren werden kann.

Bei dem Additiv-Verfahren wird die Folie mit der den Aktivator-enthaltenden Formulierung partiell, d.h. im Muster der zu erzeugenden Schaltung bedruckt, getrocknet, hinterspritzt und in ein geeignetes Metallisierungsbad, vorzugsweise Verkupferungsbad, getaucht. In dem Metallisierungsbad scheidet sich überall dort und auch nur dort, wo Paste gedruckt worden ist, eine Metallschicht ab. Die Höhe der Metallschicht, vorzugsweise Kupferschicht, ist eine Funktion der Metallisierungszeit. Im Verkupferungsbad Printoganth® ML der Fa. Schering werden in einer Stunde ca, 3 µm Kupfer abgeschieden. Bei längeren Verweilzeiten im Kupferbad können auch wesentlich höhere Kupferschichtdicken erzielt werden.

Bei dem Semiadditiv-Verfahren wird der flexible Träger mit einer einen Metallisierungsaktivator-enthaltenden Formulierung ganzflächig bedruckt, der dünn aufgebrachte Druck wird durch Trocknungs- bzw. Temperungsprozesse für eine nachfolgende stromlose Metallisierung konditioniert, dann wird ein Galvanoresist in Form des negativen Leiterbahnenbildes nach dem üblichen Stand der Technik aufgebracht, das Leiterbahnenbild wird in einem galvanischen Metallisierungsbad aufmetallisiert und nach dem Strippen des Resists wird die Metalloberfläche sauer oder alkalisch solange geätzt, bis die gewünschte Schaltung erhalten worden ist.

Zur Herstellung der "spritzgegossenen Schaltungen" werden die oben beschriebenen Folien, die einen getrockneten Auftrag einer einen Aktivator-enthaltenden Formulierung enthalten, in üblichen Spritzgußmaschinen mit thermoplastischen Materialien hinterspritzt. Dazu werden die Folien so in Spritzgußformen eingelegt, daß die unbeschichtete Folienseite mit der eingespritzten Schmelze beschichtet wird. Die Spritzgußform besitzt eine erhöhte Temperatur zwischen 70 und 150°C je nach verwendetem Thermoplast. Nach dem Schließen der Spritzgußformen wird der Thermoplast, der eine Massetemperatur zwischen 230 und 330°C besitzt, in die Form eingespritzt. Masse- und Formtemperatur hängen von der Art des Thermoplasten ab. Der Hinterspritzvorgang entspricht dem Stand der Technik.

Je nach Auswahl von Foliensubstrat und Thermoplast für das Hinterspritzen können Spritzgußteile entstehen, bei denen der Verbund von eingelegter Folie und hinterspritztem Thermoplast sehr gut ist.

Sind die ausgewählte Folie und der zu hinterspritzende Thermoplast in diesem Sinne nicht kompatibel, empfiehlt es sich, die Trägerfolie auf ihrer Rückseite vor dem Hinterspritzen mit einem Kleber zu versehen.

Selbstverständlich können alle bekannten Kleber eingesetzt werden, mit denen man üblicherweise Kunststoffsubstrate miteinander verkleben kann. Für das Hinterspritzen von verschiedenen Folien mit unterschiedlichen Thermoplasten haben sich Einkomponenten- oder Zweikomponenten-Klebstoffe auf Polyurethanbasis bewährt.

Beispiele sind der Einkomponenten-Polyurethanklebstoff Dispercoll® U 42 der Bayer AG oder der Zweikomponenten-Klebstoff auf Polyurethanbasis mit der Basiskomponente Liofol® UK 3645 und der Vernetzungskomponente Härter UR 6210-22 der Fa, Henkel. Hingewiesen werden sollte außerdem auf die Klebstoffe, die zur Herstellung von Schichtstoffen in der DE-OS 36 19 032 aufgeführt worden sind.

Im Sinne des Verfahrens gemäß der Erfindung verwendbare Thermoplaste für das Hinterspritzen sind ABS-Copolymerisate, Polycarbonate, Blends aus ABS und Polycarbonat, Polyamide, Polyetherimide, Polyethersulfone, Polyetheretherketone, Polyphenylensulfid. Diese sind die bevorzugten Thermoplasten für das Hinterspritzen zur Herstellung spritzgegossener Schaltungen. Selbstverständlich kommen alle in der Kunststoffspritztechnik gebräuchlichen Thermoplaste in Betracht.

In einer besonderen Ausführungsform der Erfindung werden die flexiblen Schaltungen - insbesonderen dann, wenn kompliziertere geometrische Formen erzeugt werden sollen, - entsprechend der äußeren Spritzgußform der herzustellenden elektronischen Schaltung dreidimensional vorgeformt. Das Vorformen der flexiblen Träger erfolgt bevorzugt nach bekannten Blasformtechniken. Dazu können übliche Vakuum- oder Preßluftverfahren zur Anwendung gelangen. Bevorzugt angewendet wird jedoch eine Hochdruckverformungstechnik, die in der DE-OS 3840542 beschrieben ist. Diese blasverformten flexiblen Träger können bereits den getrockneten Aufdruck der Aktivatorenthaltenden Formulierung aufweisen, der nach dem Hinterspritzen in einem Metallisierungsbad noch metallisiert wird.

Selbstverständlich ist es möglich, die fertigen spritzgegossenen Leiterplatten zum Schutz vor mechanischen Einwirkungen und Schmutz auch auf der die Leiterbahn tragenden Seite zu hinterspritzen, so daß die Schaltung praktisch "eingegraben" (buried) ist.

Nach den oben beschriebenen Techniken lassen sich ebenso zweilagige, durchkontaktierte Schaltungen erzeugen. Auch die zweilagigen Schaltungen k8nnen zur Herstellung spritzgegossener Leiterplatten hinterspritzt werden, wobei zwangsläufig eine Leiterbahnebene verdeckt ("eingegraben", buried) ist.

Die folgenden Beispiele sollen zur Erläuterung der vorliegenden Erfindung dienen, ohne dabei den Umfang der Erfindung einzuschränken.

### Beispiel 1

Auf einer Polyesterfolie Hostaphan® der Fa. Hoechst wurde durch partielles Verdrucken einer Siebdruckpaste gemäß DE-OS 36 27 256 ein Schaltungsdruck hergestellt. Dieser wurde 1 h bei 150°C getrocknet. Danach wurde die Rückseite dieser Folie mit einem Einkomponentenkleber auf Polyurethan-Basis (PU 8100 der Fa. Bayer AG) beschichtet (Feuchteauftrag 100 µm). Der Kleber wurde an der Luft getrocknet. Die so behandelte Folie wurde in eine Spritzgußform eingelegt, wobei die mit dem Kleber-beschichtete Seite zur Einspritzdüse ausgerichtet war. Formtemperatur: 90°C. Hinterspritzt wurde mit Polycarbonat mit einer Massetemperatur von 300°C. Nach dem Entformen haftete die Polyesterfolie auf dem Polycarbonat-Spritzgußteil sehr gut.

Nach dem Hinterspritzen erfolgte nun erst die Metallisierung der aufgedrucktden Siebdruckpaste durch Eintauchen des Spritzgußteils in das Kupferbad Printoganth® ML der Fa. Schering. Dabei wurden in ca. 1 h 3 µm auf den gedruckten Stellen abgeschieden, so daß eine funktionstüchtige dreidimensionsionale Schaltung entstand.

### Beispiel 2

Eine Polyimidfolie Kapton® VN der Fa. Dupont (75 µm dick) wurde mit einer Siebdruckpaste, die gemäß DE-OS 37 43 780 einen Metallisierungsaktivator enthielt, partiell d.h. in Form eines Leiterbahnenbildes bedruckt. Der Druck wurde mit einer Siebdruckmaschine ausgeführt. Nach einer Trocknung bei 230°C wurde die Rückseite dieser Folie mit einem Einkomponentenkleber auf Polyurethan-Basis beschichtet und wie beschrieben, in eine Spritzgußform eingelegt und hinterspritzt. Formtemperatur: 150°C. Als Thermoplast wurde Polyphenylensulfid (Tedur®, Fa. Bayer AG) mit einer Massetemperatur von 330°C eingesetzt.

Nach dem Hinterspritzen erfolgte nun erst die Metallisierung der aufgedruckten Siebdruckpaste durch Eintauchen des Spritzgußteils in das Kupferbad Printoganth® ML der Fa. Schering. Dabei wurden in etwa 1 Stunde 3 µm Kupfer auf den gedruckten Stellen abgeschieden, so daß eine funktionstüchtige dreidimensionale Schaltung entstand.

### Beispiel 3

Auf eine 50 µm Polyimidfolie wurde eine Formulierung gemäß DE-OS 37 43 780 aufgerakelt (ca. 20 µm) und bei 210°C getrocknet. Anschließend wurde auf die Folie ein Galvanoresist mit dem Negativbild einer Schaltung aufgebracht. Die Folie mit dem Schaltungsbild wurde gemäß DE-OS 38 40 542 blasverformt, mit Polyphenylensulfid (PPS) hinterspritzt und anschließend stromlos eine Schaltung mit einer Kupferschichtdicke von 5 µm aufgebaut.

## Patentansprüche

1. Verfahren zur Herstellung spritzgegossener Leiterplatten durch Hinterspritzen von flexiblen Schaltungen in Spritzgußformen mit einem thermoplastischen Polymermaterial, dadurch gekennzeichnet, daß flexible Träger eingesetzt werden, auf deren Oberfläche eine einen Metallisierungsaktivator enthaltende Pastenformulierung entweder
a) in Form des Leiterbahnenbildes aufgedruckt ist, und nach dem Hinterspritzen und Sensibilisieren durch Reduktion in einem chemischen, stromlosen Metallisierungsbad eine Metallschicht in Form des gewünschten Leiterbahnenbildes und in der Höhe von 0,05 - 10 µm aufgebaut wird, oder
b) ganzflächig aufgebracht wird, und nach dem Hinterspritzen und Sensibilisieren durch Reduktion in einem chemischen, stromlosen Metallisierungsbad eine 2 - 3 µm dicke Metallschicht ganzflächig aufgebaut wird, auf deren Basis nachfolgend nach der Semiadditiv-Technik ein Leiterbahnenbild aufgebaut wird, oder
c) ganzflächig aufgebracht wird, dann in Form des negativen Leiterbahnenbildes ein Galvanoresist aufgebracht wird, und nach dem Hinterspritzen und Sensibilisieren durch Reduktion in einem chemischen, stromlosen Metallisierungsbad eine Metallschicht mit einer Dicke von 0,05 - 10 µm in Form des Leiterbahnenbildes aufgebaut wird, wobei in allen Ausführungsformen a), b) und c) das Sensibilisieren durch Reduktion durch das Metallisierungsbad durchgeführt werden kann.

2. Verfahren nach Anspruch 1, dadurch gekennzeichnet, daß die flexiblen Träger, auf denen die einen Metallisierungsaktivator enthaltende Pastenformulierung aufgebracht ist, vor dem Hinterspritzen nach der Blasverformtechnik vorgeformt werden.

## Claims

1. Method for the production of injection-moulded circuit boards by injection moulding behind flexible circuits in injection moulds using a thermoplastic polymeric material, characterised in that flexible substrates are used on the surface whereof a paste formulation containing a metallisation activator is either
a) printed in the form of the strip conductor pattern and, after the injection moulding behind and sensitisation by reduction, a metal layer is built up in the form of the desired strip conductor pattern and to a depth of from 0.05 to 10 µm in a chemical, currentless metallisation bath, or
b) applied overall and, after the injection moulding behind and sensitisation by reduction, a metal layer of 2 to 3 µm in thickness is built up overall in a chemical, currentless metallisation bath, on which foundation a strip conductor pattern is subsequently built up by means of the semi-additive technique, or
c) applied overall, then a galvanoresist in the form of the negative strip conductor pattern is applied and, after the injection moulding behind and sensitisation by reduction, a metal layer having a thickness of from 0.05 to 10 µm is built up in the form of the strip conductor pattern in a chemical, currentless metallisation bath, wherein in all the embodiments a), b) and c) the sensitisation by reduction can be carried out using the metallisation bath.

2. Method according to claim 1, characterised in that the flexible substrates, whereon the paste formulation containing a metallisation activator is applied, are preformed by the blow moulding technique prior to the injection moulding.

## Revendications

1. Procédé pour la préparation de plaquettes de circuits imprimés moulées par injection arrière de circuits souples dans des moules de moulage par injection avec un matériau polymère thermoplastique, caractérisé en ce qu'on utilise des supports souples sur les surfaces desquels une formulation de pâte contenant un activateur de métallisation est soit
a) appliquée dans la forme du placage métallique sélectif, et après l'injection arrière et la sensibilisation par réduction dans un bain de métallisation chimique, sans courant, est construite une couche métallique dans la forme du placage métallique sélectif souhaité et selon la hauteur de 0,05-10 µm, soit
b) appliquée sur toute la surface, et après l'injection arrière et la sensibilisation par réduction dans un bain de métallisation chimique, sans courant, est construite sur toute la surface une couche métallique d'épaisseur 2-3 µm, sur la base de laquelle est construit ensuite un placage métallique sélectif selon la technique semi-additive, ou
c) appliquée sur toute la surface, puis un galvanorésist est appliqué dans la forme du placage métallique sélectif négatif, et après l'injection arrière et la sensibilisation par réduction dans un bain de métallisation chimique, sans courant, est construite une couche métallique avec une épaisseur de 0,05-10 µm dans la forme du placage métallique sélectif, dans tous les modes de réalisation a), b) et c) la sensibilisation par réduction pouvant être réalisée par l'intermédiaire du bain de métallisation.

2. Procédé selon la revendication 1, caractérisé en ce que les supports souples, sur lesquels on applique la formulation de pâte contenant un activateur de métallisation, sont préformés avant l'injection arrière selon la technique de soufflage.
